Europäisches Patentamt

(19) European Patent Office

Office européen des brevets

(11) Numéro de publication : **0 296 038 B1**

(12) # FASCICULE DE BREVET EUROPEEN

(45) Date de publication du fascicule du brevet :
06.11.91 Bulletin 91/45

(51) Int. Cl.⁵ : **G11C 16/06**

(21) Numéro de dépôt : **88401433.3**

(22) Date de dépôt : **10.06.88**

(54) **Mémoire EPROM effaçable par impulsions.**

(30) Priorité : 16.06.87 FR 8708377

(43) Date de publication de la demande :
21.12.88 Bulletin 88/51

(45) Mention de la délivrance du brevet :
06.11.91 Bulletin 91/45

(84) Etats contractants désignés :
DE ES GB IT NL

(56) Documents cités :
EP-A- 0 114 504
US-A- 4 366 555
TOSHIBA REVIEW, no. 153, 1985, pages 45-48,
Tokyo, JP; S. TANAKA et al.: "1M bit CMOS
EPROM"

(73) Titulaire : SGS-THOMSON
MICROELECTRONICS S.A.
7, Avenue Galliéni
F-94250 Gentilly (FR)

(72) Inventeur : Calzi, Philippe Marie Michel
20 Lotissement le Petit Nice
F-13320 Bouc Bel Air (FR)

(74) Mandataire : Ballot, Paul Denis Jacques
Cabinet Ballot-Schmit 7, rue le Sueur
F-75116 Paris (FR)

## Description

L'invention concerne un procédé pour effacer une mémoire EPROM électriquement, et une mémoire EPROM spécialement conçue pour pouvoir être effacée par ce procédé.

Dans une mémoire EPROM chaque élément de stockage d'informations ou cellule-mémoire est constitué par un transistor MOS à grille flottante qui peut être principalement de type FAMOS (floating gate avalanche injection MOS) ou de type SAMOS (stacked gate avalanche injection MOS). Ce type de transistors peut avoir deux états.

Ainsi dans le cas d'un transistor MOS à canal N, dans un premier état aucune charge n'est piégée sur la grille flottante. Un canal de conduction peut exister entre la source et le drain. Le transistor conduit et il se comporte comme un interrupteur fermé. Dans un deuxième état, des électrons sont piégés sur la grille flottante. Ils empêchent la création d'un canal de conduction dans le substrat entre la source et le drain. Dans ce cas le transistor est bloqué et se comporte comme un interrupteur ouvert.

La programmation d'un transistor MOS à grille flottante se fait généralement en appliquant une haute tension continue, plus élevée que la tension de fonctionnement normale, sur la grille de commande et une haute tension continue un peu plus faible que la précédente sur le drain par exemple. La tension appliquée sur la grille de commande est par exemple de l'ordre de 12,5 volts et la tension appliquée sur le drain est par exemple de l'ordre de 10 volts.

La source est à la masse. Les électrons sont soumis à deux champs électriques l'un horizontal entre la source et le drain et l'autre vertical entre le drain et la grille de commande. Le champ électrique vertical va dévier la trajectoire de certains électrons et ils vont se piéger sur la grille flottante.

Dans ce type de mémoire l'effacement se fait par l'application d'un rayon ionisant, des rayons ultraviolets par exemple. Ce rayonnement apporte aux électrons piégés une énergie suffisante pour quitter la grille flottante.

Les mémoires EPROM de ce type doivent être encapsulées dans des boîtiers comportant une fenêtre afin que le rayonnement ultraviolet atteigne la cellule-mémoire à effacer.

Un opérateur doit donc pour effacer une mémoire de ce type manipuler le boîtier qui la contient pour le soumettre au rayonnement ultraviolet.

Les mémoires EPROM classiques ne sont pas effaçables électriquement de la même manière qu'elles sont programmées ; car une fois que des électrons ont été piégés en quantité suffisante, le transistor ne peut plus être rendu conducteur et on ne peut donc pas procéder simplement en inversant les potentiels utilisés lors de la programmation. On a toutefois proposé des mémoires EPROM effaçables électriquement. Chaque cellule mémoire est constituée d'un transistor MOS à grille flottante. La surface supérieure de la grille flottante en polysilicium comporte des rugosités. L'effacement s'effectue par effet de pointe entre les rugosités de la surface supérieure de la grille flottante et la grille de commande lorsqu'un potentiel positif élevé est appliqué sur la grille de commande, le substrat étant à la masse. Le brevet US 4366555 décrit une telle mémoire.

Mais on maîtrise mal cet effacement qui est très lié à la structure physique de la surface supérieure du silicium polycristallin de la grille flottante. De plus la présence de rugosités induit un risque de détérioration de la cellule.

Par ailleurs, il existe déjà des mémoires électriquement effaçables, les EEPROM par exemple. Une cellule EEPROM comprend en général un transistor MOS à grille flottante, avec amincissement local de la couche d'oxyde entre la grille flottante et le substrat, en série avec un transistor d'accès. L'effacement s'effectue dans ce cas par effet tunnel. Mais ces mémoires sont encombrantes et elles nécessitent un procédé de fabrication plus long et plus complexe que celui des EPROM.

L'invention propose, pour remédier à ces inconvénients, un procédé d'effacement électrique d'une mémoire EPROM, par effet des porteurs chauds. Ce procédé s'utilise avec une mémoire EPROM classique. La plaquette de silicium utilisée comme substrat pour la matrice de cellules mémoires de type MOS subira toutefois un traitement préliminaire, afin d'isoler soit un groupe de cellules mémoires des circuits de commande de la mémoire EPROM et des autres groupes de cellules mémoires, soit chaque cellule mémoire individuellement des circuits de commande de la mémoire EPROM et des cellules avoisinantes. Dans le premier cas le procédé selon l'invention permettra d'effacer tout le groupe de cellules mémoires isolé, dans le deuxième cas, chaque cellule mémoire sera effacée individuellement.

La mémoire EPROM effaçable par ce procédé pourra être placée dans un environnement où la facilité d'accès n'a plus d'importance, l'effacement pouvant être maintenant effectué par télétraitement à distance sur les boîtiers.

L'invention concerne un procédé pour effacer électriquement une mémoire EPROM formée d'une matrice de cellules mémoires constituées chacunes par un transistor MOS à grille flottante dont la structure comprend une source et un drain diffusés sur un substrat, séparés par un canal, une grille flottante et une grille de commande empilées l'une sur l'autre, la grille flottante étant isolée du substrat par une couche d'oxyde de grille et isolée de la grille de commande par une autre couche d'oxyde, certains transistors MOS ayant été programmés électriquement de sorte que des électrons sont piégés sur la grille flottante, caractérisé en ce que, le drain, la source et le canal des cellules mémoires à effacer étant réunis on leur applique une série de plusieurs créneaux de tension, d'amplitude positive par rapport à la grille de commande qui permettent d'extraire les électrons piégés sur la grille flottante en leur faisant franchir la couche d'oxyde de grille vers le substrat.

L'invention concerne aussi une mémoire EPROM effaçable électriquement selon la revendication 3.

D'autres avantages et les caractéristiques de l'invention apparaîtront à la lecture de la description qui va suivre avec références aux dessins ci-annexés dans lesquels :

— la figure 1 représente une vue en coupe d'une cellule mémoire à transistor MOS à grille flottante ;

— la figure 2 représente le diagramme des bandes d'énergie d'un transistor MOS à grille flottante soumis à un champ électrique ;

— la figure 3 représente une vue en coupe d'une cellule mémoire à transistor MOS isolée individuellement par double implantation de puits ;

— la figure 4 représente une vue en coupe d'une cellule mémoire à transistor MOS isolée individuellement par implantation d'oxygène forte énergie.

Pour simplifier la description, dans les dessins les mêmes éléments portent les mêmes références.

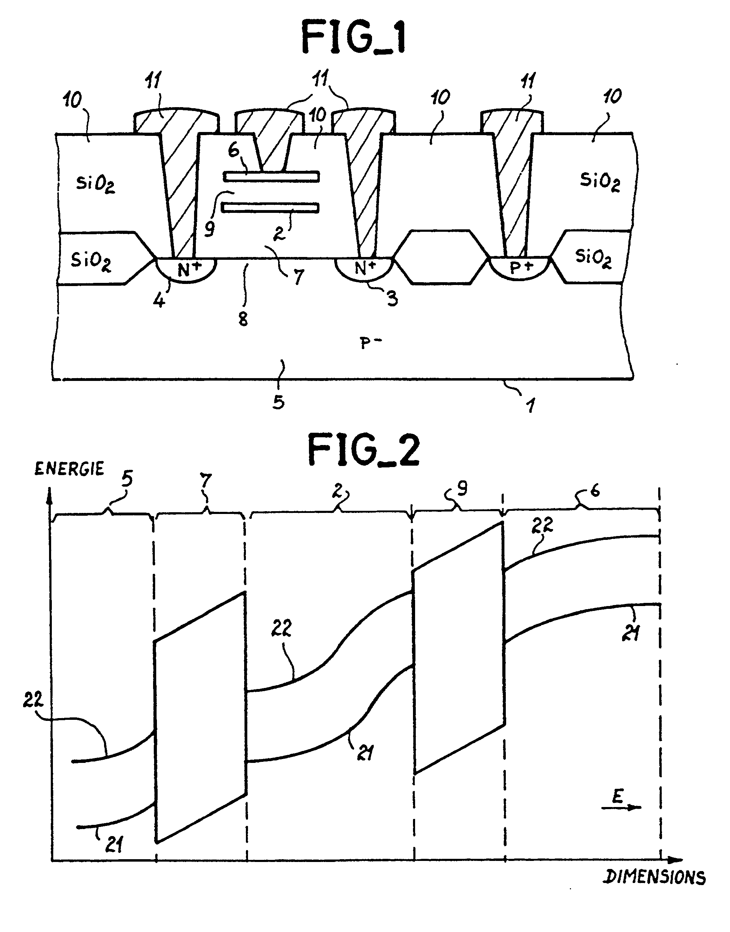

La figure 1 représente une cellule mémoire 1 du type à transistor MOS à grille flottante 2. La mémoire EPROM selon l'invention est constituée d'une matrice de cellules mémoires 1.

Chaque transistor MOS possède deux électrodes, respectivement le drain 3 et la source 4 diffusées sur un substrat 5 et séparées par un canal 8. Une grille de commande 6 est empilée sur la grille flottante 2 elle-même empilée sur le substrat. La grille flottante 2 est isolée du substrat 5 par de l'oxyde de grille 7. Elle est aussi isolée de la grille de commande 6 par une autre couche de diélectrique 9. Une troisième couche de diélectrique 10 recouvre l'ensemble. Des plots métalliques 11 assurent les contacts pour l'alimentation du drain 3, de la source 4, de la grille de commande 6 et du substrat 5.

Dans l'exemple représenté il s'agit d'un transistor MOS à canal N. Le drain 3 et la source 4 sont constitués par des diffusions $n^+$ dans un substrat 5 de type $p^-$. La grille de commande 6 et la grille flottante 2 sont réalisées par exemple en silicium polycristallin. La couche d'oxyde de grille 7 est par exemple en oxyde de silicium. La couche de diélectrique 9 ou oxyde interpolysilicium, la couche de diélectrique 10 peuvent être également en oxyde de silicium.

Le drain 3, la source 4, le canal 8 des cellules mémoires à effacer étant réunis, le procédé d'effacement consiste à leur appliquer une série de plusieurs créneaux de tension d'amplitude positive par rapport à la grille de commande.

Le drain 3, la source 4, le canal 8 sont réunis et reçoivent des créneaux de tension d'amplitude environ 13 volts. Cette tension est fonction de l'épaisseur de la couche d'oxyde de grille qui dans notre exemple est de l'ordre de 250 Å. La grille de commande est mise à la masse. Les temps de montée des créneaux sont de préférence inférieurs à lus et le nombre de créneaux pour effectuer l'effacement d'une cellule est de l'ordre de $10^3$. A titre d'exemple, on peut effectuer un effacement excellent avec $10^3$ créneaux, de temps de montée d'environ 300 ns, à une fréquence de 1 MHz.

La figure 2 représente le diagramme des bandes d'énergie d'une structure MOS à grille flottante soumise à un champ électrique E.

En abscisse on retrouve les dimensions des couches de la structure et en ordonnée l'énergie des électrons.

Le substrat 5 est surmonté de la grille flottante 2 elle-même surmontée de la grille de commande 6. La grille flottante 2 est isolée du substrat par une couche d'oxyde de grille 7 et est isolée de la grille de commande par une autre couche d'oxyde 9.

Dans un semiconducteur on définit deux bandes d'énergie, la bande de valence 21 correspondant aux énergies les plus faibles et la bande de conduction 22 correspondant aux énergies les plus fortes. Lorsque l'on n'amène aucune énergie à la structure, à basse température, les électrons remplissent la bande de valence et la bande de conduction est pratiquement vide.

Lorsque l'on applique un signal périodique aux électrodes et au substrat d'un transistor MOS les bandes d'énergie 21, 22 de la structure vont se courber et suivre l'évolution du potentiel.

Sur une cellule-mémoire programmée il n'y a que quelques électrons ou porteurs libres qui sont stockés sur la grille flottante 2.

Ces porteurs libres vont acquérir de l'énergie. Mais ils ne sont pas en nombre suffisant pour contrecarrer la courbure des bandes d'énergie. Pour rétablir l'équilibre des bandes il va y avoir création de paires électrons-trous. Cette création de paires électrons-trous n'est pas instantanée.

Les porteurs libres stockés sont alors soumis à un champ électrique supérieur à celui qui existe à l'équilibre. Ils sont fortement accélérés et vont passer de la grille flottante 2 vers le substrat 5. Pendant leur déplacement ils vont subir des chocs avec le réseau cristallin et perdre une partie de leur énergie. Ce procédé est dit par effet de porteurs chauds. A chaque créneau certains électrons seulement pourront franchir la couche d'oxyde de grille 7, ceux qui auront acquis le plus d'énergie. En appliquant plusieurs créneaux successifs à la structure, on pourra extraire tous les porteurs libres injectés à la programmation.

Cet effet d'effacement ne se produit que pendant le front montant des créneaux, pendant que les bandes d'énergie sont en déséquilibre. La création de paires électrons-trous rétablit l'équilibre des bandes. C'est pourquoi il est préférable que le temps de montée des créneaux soit inférieur au temps de génération-recombinaison des paires électrons-trous. Avec ce procédé on n'extrait que les électrons qui ont été injectés à la programmation. Il y a accumulation profonde d'électrons à l'interface entre la grille flottante 2 et la couche d'oxyde de grille 7.

On notera que la simple application d'un potentiel élevé de 12 à 20 volts sur le substrat par rapport à la grille ne permettrait pas d'obtenir l'effacement. Au contraire, l'application d'une série de créneaux à fronts de montées raides permet selon l'invention l'effacement.

Le courant d'effacement est faible, de l'ordre du picoampère, car on ne "chauffe" que les électrons que l'on va extraire. Le courant utilisé pour la programmation est plus important, de l'ordre du milliampère.

L'efficacité d'effacement est importante. Toute la surface du canal 8 représenté sur la figure 1 est utilisée. Cette surface correspond à la surface de la grille flottante 2 ou à la surface de la couche d'oxyde de grille 7.

Plus la surface de passage est grande plus le temps d'effacement sera faible.

Pour la programmation il y a une zone de pincement et la surface ne couvre qu'une petite partie de la surface du canal 8 et la surface utilisée ne couvre qu'une petite partie de la surface du canal 8.

Ce procédé d'effacement peut être utilisé avec des mémoires EPROM existantes.

Mais pour que l'ensemble des circuits de la mémoire fonctionne pendant l'effacement il est souhaitable que les cellules mémoires soient formées dans des caissons isolés des circuits de commande. Dans ce cas on peut prévoir qu'un caisson isolé englobe un groupe de cellules mémoires. Des contacts d'accès à ce caisson permettront d'appliquer les créneaux de tension sur toutes les cellules mémoires du groupe et on obtiendra l'effacement total du groupe de cellules mémoires. Le groupe peut éventuellement contenir toutes les cellules mémoires de la mémoire EPROM réalisée selon l'invention.

Selon une variante on peut prévoir que chaque cellule mémoire soit isolée dans un caisson. Un contact d'accès à ce caisson permettra d'appliquer les séries de créneaux utilisés pour l'effacement. Chaque cellule mémoire sera effacée individuellement et l'effacement ne perturbera pas le fonctionnement des cellules avoisinantes ni celui des circuits de commande de la mémoire.

La réalisation de l'isolation pourra se faire selon l'une ou l'autre des méthodes décrites ci-dessous. Ces méthodes s'utilisent aussi bien pour l'isolation d'un groupe de cellules mémoires que pour l'isolation de chaque cellule mémoire.

La surface de mémoires EPROM selon l'invention est d'environ 30 µm². Les mémoires EEPROM de type connu font environ 100 µm². L'utilisation de EPROM à la place de EEPROM permet un gain de place important, ce qui est toujours recherché dans l'industrie des circuits intégrés.

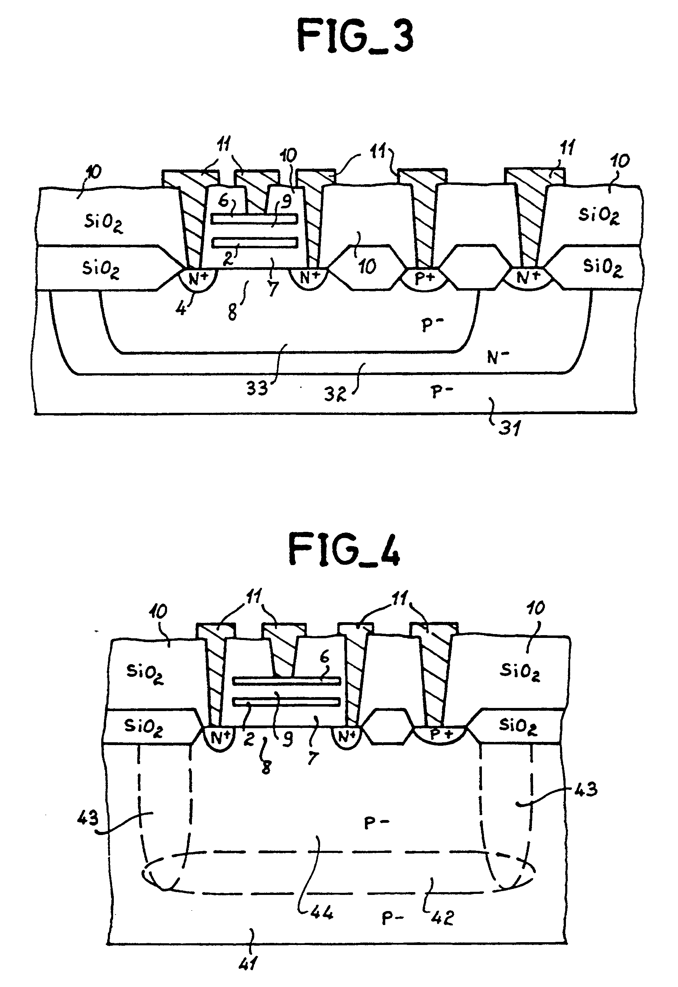

La figure 3 représente en coupe une cellule mémoire isolée individuellement selon une première réalisation.

Cette isolation peut se faire par double diffusion de puits. Dans l'exemple représenté le substrat 31 général de la mémoire EPROM est de type p⁻. On diffuse un premier puits 32 de type inverse n⁻. A l'intérieur de ce puits on diffuse un deuxième puits 33 de type inverse soit p⁻. Cette diffusion est simple à réaliser par masques. L'implantation du transistor MOS à grille flottante se fait par le procédé habituel sur le substrat de type p⁻ 33 isolé.

Quand on applique la série de créneaux pour l'effacement on met en avalanche la jonction p⁻ · n⁻ (33, 32) qui est totalement isolée du substrat de départ 31. Cela créera un courant parasite qui impliquera un courant d'effacement un peu plus important.

La figure 4 représente en coupe une cellule-mémoire isolée individuellement selon un second mode de réalisation. Ce second mode de réalisation consiste en une implantation d'oxygène forte énergie. L'oxygène se combine avec le silicium du substrat général 41 de la mémoire pour former de l'oxyde de silicium. On obtient un plateau en oxyde 42 dans le substrat général 41 de type p⁻. La forte énergie permet de déterminer la profondeur d'implantation du plateau dans le substrat 41.

Pour oxyder les parois, on utilise le procédé d'implantation d'oxygène forte énergie mais en faisant varier l'énergie. On obtient donc une barrière d'oxyde verticale 43 à la périphérie du plateau 42 et qui forme avec celui-ci un caisson isolant. L'implantation du transistor MOS à grille flottante se fait par le procédé habituel sur le substrat de type p⁻ 44 isolé à l'intérieur du caisson. Avec cette réalisation il n'y a pas de courant parasite lors de l'effacement mais une telle oxydation est plus délicate à réaliser.

Si l'on désire isoler un groupe de cellules-mémoires l'une ou l'autre de ces méthodes pourra s'appliquer et il suffira d'implanter ensuite le groupe de transistors MOS sur le substrat p⁻ isolé.

**Revendications**

1. Procédé pour effacer électriquement une mémoire EPROM comportant une matrice de cellules mémoires constituées chacune par un transistor MOS (1) à grille flottante dont la structure comprend :
 — une source (4) et un drain (3) diffusés sur un substrat (5) et séparés par un canal (8) ;
 — une grille flottante (2) et une grille de commande (6) empilées l'une sur l'autre au dessus du substrat, la grille flottante étant isolée du substrat par une couche d'oxyde de grille (7) et de la grille de commande par une couche d'oxyde (9), certains de ces transistors MOS ayant été programmés électriquement de sorte que des électrons sont piégés sur la grille flottante, caractérisé en ce que le drain, la source, et le canal de cellules mémoires à effacer étant réunis, on leur applique une série de plusieurs créneaux de tension d'amplitude positive par rapport à la grille de commande de sorte qu'ils permettent d'extraire les électrons piégés sur la grille flottante en leur faisant franchir la couche d'oxyde de grille vers le substrat.

2. Procédé pour effacer une mémoire EPROM selon la revendication 1, caractérisé en ce que le temps de montée des créneaux est inférieur à une constante de temps correspondant au temps de génération-recombinaison moyen des paires électrons-trous.

3. Mémoire EPROM comportant une matrice de cellules mémoires constituées chacune par un transistor MOS (1) à grille flottante dont la structure comprend :

   — une source (4) et un drain (3) diffusés sur un substrat (5) et séparés par un canal (8) ;
   — une grille flottante (2) et une grille de commande (6) empilées l'une sur l'autre au dessus du substrat, la grille flottante étant isolée du substrat par une couche d'oxyde de grille (7) et de la grille de commande par une couche d'oxyde (9), certains de ces transistors MOS ayant été programmés électriquement de sorte que des électrons sont piégés sur la grille flottante, caractérisée par des moyens pour réunir le drain, la source, et le canal de cellules mémoires à effacer, et leur appliquer une série de plusieurs créneaux de tension d'amplitude positive par rapport à la grille de commande de sorte qu'ils permettent d'extraire les électrons piégés sur la grille flottante en leur faisant franchir la couche d'oxyde de grille vers le substrat.

4. Mémoire EPROM selon la revendication 3, caractérisée en ce que le temps de montée des créneaux est inférieur à une constante de temps correspondant au temps de génération-recombinaison moyen des paires électrons-trous.

5. Mémoire EPROM selon les revendications 3 ou 4, caractérisée en ce que au moins un groupe de cellules mémoires est englobé dans un caisson isolant (32, 42, 43) de sorte que l'effacement d'un groupe de cellules mémoires ne perturbe pas le fonctionnement des circuits de commande de la mémoire.

6. Mémoire EPROM selon les revendications 3 ou 4, caractérisée en ce chaque cellule mémoire la composant est isolée (22, 42, 43) des autres cellules mémoires de sorte que l'effacement d'une cellule mémoire ne perturbe pas le fonctionnement des cellules mémoires avoisinantes, ni celui des circuits de commande de la mémoire.

7. Mémoire EPROM selon les revendications 5 ou 6, caractérisée en ce que l'isolation d'au moins un groupe de cellules mémoires ou de chaque cellule mémoire est réalisée par diffusion d'un premier puits (32) de type inverse de celui du substrat général (31) de la mémoire EPROM et par diffusion à l'intérieur du premier puits d'un deuxième puits (33) de même type que celui du substrat général.

8. Mémoire EPROM selon les revendications 5 ou 6, caractérisée en ce que l'isolation d'au moins un groupe de cellules mémoires ou de chaque cellule mémoire est réalisée dans un premier temps par implantation d'oxygène forte énergie en profondeur dans le substrat général (41) de la mémoire afin d'obtenir un plateau (42) en oxyde et dans un deuxième temps par implantation d'oxygène forte énergie à la périphérie du plateau ainsi créé, en faisant varier l'énergie afin d'obtenir une barrière verticale (43) qui forme avec le plateau (42) un caisson en oxyde.

## Patentansprüche

1. Verfahren zum elektrischen Löschen eines EPROM- Speichers mit einer Matrix von Speicherzellen, die jeweils von einem MOS-Transistor (1) mit schwebendem Gate gebildet werden, dessen Struktur umfaßt :

   — eine Source (4) und einen Drain (3), die in ein Substrat (5) eindiffundiert sind und durch einen Kanal (8) getrennt werden ;
   — ein schwebendes Gate (2) und ein Steuergate (6), die oberhalb des Substrats aufeinandergeschichtet sind, wobei das schwebende Gate vom Substrat durch eine Gateoxidschicht (7) und vom Steuergate durch eine Oxidschicht (9) isoliert ist, wobei bestimmte dieser MOS-Transistoren elektrisch programmiert werden, derart, daß vom schwebendem Gate Elektronen eingefangen werden, dadurch gekennzeichnet, daß auf den Verbund von Drain, Source und Kanal der zu löschenden Speicherzellen eine Reihe mehrerer Spannungsimpulse mit in bezug auf das Steuergate positiver Amplitude angelegt wird, derart, daß diese das Herausziehen der vom schwebenden Gate eingefangenen Elektronen ermöglichen, indem die Elektronen dazu veranlaßt werden, die Gateoxidschicht in Richtung des Substrats zu durchqueren.

2. Verfahren zum Löschen eines EPROM-Speichers gemäß Anspruch 1, dadurch gekennzeichnet, daß die Anstiegszeit der Impulse kleiner als eine Zeitkonstante ist, die der mittleren Erzeugungs/Rekombinations-Zeit von Elektron/Loch-Paaren entspricht.

3. EPROM-Speicher mit einer Matrix von Speicherzellen, die jeweils von einem MOS-Transistor (1) mit schwebendem Gate gebildet werden, dessen Struktur umfaßt :

— eine Source (4) und einen Drain (3), die in ein Substrat (5) eindiffundiert sind und durch einen Kanal (8) getrennt werden ;

— ein schwebendes Gate (2) und ein Steuergate (6), die oberhalb des Substrats aufeinandergeschichtet sind, wobei das schwebende Gate vom Substrat durch eine Gateoxidschicht (7) und vom Steuergate durch eine Oxidschicht (9) isoliert ist, wobei bestimmte dieser MOS-Transistoren elektrisch programmiert worden sind, derart, daß im schwebenden Gate Elektronen eingefangen sind, gekennzeichnet durch Mittel zum Verbinden des Drains, der Source und des Kanals der zu löschenden Speicherzelle und zum Anlegen einer Reihe von mehreren Spannungsimpulsen mit in bezug auf das Steuergate positiver Amplitude auf sie, derart, daß die Spannungsimpulse das Herausziehen der im schwebenden Gate eingefangenen Elektronen ermöglichen, indem die Elektronen dazu veranlaßt werden, die Gateoxidschicht in Richtung des Substrats zu durchqueren.

4. EPROM-Speicher gemäß Anspruch 3, dadurch gekennzeichnet, daß die Anstiegszeit der Impulse kleiner als eine Zeitkonstante ist, die der mittleren Erzeugungs/Rekombinations-Zeit der Elektron/Loch-Paare entspricht.

5. EPROM-Speicher gemäß den Ansprüchen 3 oder 4, dadurch gekennzeichnet, daß wenigstens eine Gruppe von Speicherzellen in einem Isolierkasten (32, 42, 43) eingeschlossen ist, derart, daß die Löschung einer Gruppe von Speicherzellen die Funktion der Steuerschaltungen des Speichers nicht stört.

6. EPROM-Speicher gemäß den Ansprüchen 3 oder 4, dadurch gekennzeichnet, daß jede ihn aufbauende Speicherzelle von den anderen Speicherzellen isoliert ist (22, 42, 43), derart, daß die Löschung einer Speicherzelle weder die Funktion der benachbarten Speicherzellen noch diejenige der Steuerschaltungen des Speichers stört.

7. EPROM-Speicher gemäß den Ansprüchen 5 oder 6, dadurch gekennzeichnet, daß die Isolation wenigstens einer Gruppe von Speicherzellen oder einer jeden Speicherzelle durch die Diffusion eines ersten Schachts (32) eines zu demjenigen des allgemeinen Substrats (31) des EPROM-Speichers inversen Typs und durch Diffusion eines zweiten Schachts (33) desselben Typs wie das allgemeine Substrat in das Innere des ersten Schachts verwirklicht wird.

8. EPROM-Speicher gemäß den Ansprüchen 5 oder 6, dadurch gekennzeichnet, daß die Isolation wenigstens einer Gruppe von Speicherzellen oder einer jeden Speicherzelle dadurch verwirklicht wird, daß in einem ersten Zeitpunkt Sauerstoff mit hoher Energie tief in das allgemeine Substrat (41) des Speichers implantiert wird, um eine Oxidplatte (42) zu erhalten, und daß in einem zweiten Zeitpunkt Sauerstoff mit hoher Energie an den Umfang der so gebildeten Platte implantiert wird, indem die Energie verändert wird, um eine senkrechte Sperre (43) zu erhalten, die mit der Platte (42) einen Oxidkasten bildet.

## Claims

1. A method of electrically erasing an EPROM comprising a matrix of memory cells each constituted by a MOS transistor (1) having a floating gate and whose structure includes :

— a source (4) and a drain (3) diffused on a substrate (5) and separated by a channel (8) ;

— a floating gate (2) and a control gate (6) stacked on each other above the substrate, the floating gate being insulated from the substrate by a gate layer of oxide (7) and from the control gate by an oxide layer (9), certain ones of said MOS transistors having been electrically programmed in such a manner that the electrons are trapped on the floating gate, characterized in that the drain, the source and the channel of memory cells to be erased being connected, a series of several gating pulses with a positive amplitude in relation to the control gate is applied in such a manner that they make it possible to extract the trapped electrons on the floating gate by causing them to go through gate oxide layer into the substrate.

2. The method of erasing an EPROM as claimed in claim 1, characterized in that the rise time of the gating pulses is less than a time constant corresponding to the mean generation-recombination time of the electron-hole pairs.

3. An EPROM comprising a matrix of memory cells each constituted by a MOS transistor (1) with a floating gate whose structure comprises :

— a source (4) and a drain (3) diffused on a substrate (5) and separated by a channel (8) ;

— a floating gate (2) and a control gate (6) stacked on each other over the substrate, the floating gate being insulated from the substrate by a gate oxide layer (7) and from the control gate by an oxide layer (9), certain ones of the MOS transistors having been electrically programmed in such a manner that electrons are trapped on the floating gate, characterized by means to connect the drain, the source and the channel of the memory cells to be erased, and to apply to them a series of several gating pulses with a positive amplitude voltage in relation to the control gate in such a manner that they make it possible to extract the electrons trapped on the floating gate by causing them to go through the gate oxide layer to the substrate.

4. The EPROM as claimed in claim 3, characterized in that the rise time of the gating pulses is less than a time constant corresponding to the mean generation-recombination time of the electron-hole pairs.

5. The EPROM as claimed in claim 3 or claim 4, characterized in that at least one group of memory cells is encased in an insulating island (32, 42 and 43) in such a manner that the erasure of one group of memory cells does not interfere with the function of the control circuits of the memory.

6. The EPROM as claimed in claim 3 or claim 4, characterized in that each memory cell constituting the same is insulated (22, 42 and 43) from the other memory cells in such a manner that the erasure of one memory cell does not interfere with the function of adjacent memory cells or the function of the control circuit of the memory.

7. The EPROM as claimed in claim 5 or claim 6, characterized in that the insulation of at least one group of memory cells or of each memory cell is produced by a diffusion of a first trough (32) of a type which is inverse in relation to the substrate (31) as a whole and by diffusion inside the first trough of a second trough (33) of the same type as the substrate as a whole.

8. The EPROM as claimed in claim 5 or claim 6, characterized in that the insulation of at least one group of memory cells or of each memory cell is produced in a first stage by the deep implantation of high energy oxygen into the whole substrate (41) of the memory in order to produce an oxide plateau (42) and in a second stage the implantation of high energy oxygen at the periphery of the plateau so produced, by causing a variation of the energy in order to produce a vertical barrier (43) which with the plateau (42) constitutes an oxide island.

# FIG_1

# FIG_2

# FIG_3

# FIG_4